Europäisches Patentamt

European Patent Office

Office européen des brevets

(11) Veröffentlichungsnummer: **0 168 509**
**B1**

(12) EUROPÄISCHE PATENTSCHRIFT

(45) Veröffentlichungstag der Patentschrift:
**22.03.89**

(21) Anmeldenummer: **84108324.9**

(22) Anmeldetag: **16.07.84**

(51) Int. Cl.⁴: **H 05 K 3/00,** H 05 K 3/42

(54) Herstellung von Verbindungslöchern in Kunstoffplatten und Anwendung des Verfahrens.

(43) Veröffentlichungstag der Anmeldung:
**22.01.86 Patentblatt 86/4**

(45) Bekanntmachung des Hinweises auf die Patenterteilung:
**22.03.89 Patentblatt 89/12**

(84) Benannte Vertragsstaaten:
**DE FR GB**

(56) Entgegenhaltungen:
US-A- 3 099 608
US-A- 3 778 900
US-A- 4 012 307
US-A- 4 247 600
US-A- 4 367 119

EXTENDED ABSTRACTS, Band 83, Nr. 1, Mai 1983, Seite 290, Zusammenfassung Nr. 179, Pennington, N.J., US; T.O. HERNDON u.a.: "Plasma etching ov vias in polyimide using nonerodible masks"
CHEMICAL ABSTRACTS, Band 95, Nr. 22, 30. November 1981, Seite 397, Nr. 193040f, Columbus, Ohio, US; J. FRIEDRICH: "Reaction kinetic processes at the interface between nonisothermal plasma and solid" & BEITR. PLASMAPHYS. 1981, 21(4), 261-277

(73) Patentinhaber: **IBM DEUTSCHLAND GMBH, Pascalstrasse 100, D-7000 Stuttgart 80 (DE)**

(84) Benannte Vertragsstaaten: **DE**

(73) Patentinhaber: **International Business Machines Corporation, Old Orchard Road, Armonk, N.Y. 10504 (US)**

(84) Benannte Vertragsstaaten: **FR GB**

(72) Erfinder: **Cziep, Werner, Taubenstrasse 2, D-7031 Altdorf (DE)**
Erfinder: **Künzel, Ulrich, Dr. Dipl.-Chem., August Lämmlestrasse 8, D-7408 Kusterdingen (DE)**
Erfinder: **Ruh, Wolf-Dieter, Dipl.-Ing., Sommerhofenstrasse 152/1, D-7032 Sindelfingen (DE)**

(74) Vertreter: **Oechssler, Dietrich, Dr. rer. nat., IBM Deutschland GmbH Patentwesen und Urheberrecht Schönaicher Strasse 220, D-7030 Böblingen (DE)**

Beschreibung

Die Erfindung betrifft ein Verfahren zum Herstellen von Verbindungslöchern in glasfaserverstärkten Kunststoffplatten und eine Anwendung dieses Verfahrens zur Herstellung von Kunststoffplatten mit ein- oder beidseitig aufgebrachten Leiterzugmustern und leitenden Durchführungen, die leitend mit den Leiterzugmustern verbunden sind.

Das Verfahren findet insbesondere Anwendung bei der Herstellung von mehrschichtigen Grundplatten. Solche Grundplatten sind Laminate aus mehreren glasfaserverstärkten Kunststoffplatten, bei denen auf jeder zweiten ein- oder beidseitig ein Leiterzugmuster aufgebracht ist. Die Leiterzugmuster sind untereinander durch Kupferschichten an den Wänden von Verbindungslöchern in den Kunststoffplatten leitend verbunden. Zu den Verfahren, welche zur Herstellung der mehrschichtigen Grundplatten geeignet sind, gehört beispielsweise die sog. «Pin-parallel Method». Dieses Verfahren ist in dem Artikel «Highdensity board fabrication techniques» von J.R. Bub u.a., der im IBM Journal of Research and Development, Bd. 26, Nr. 3, Mai 1982, Seiten 306ff. veröffentlicht worden ist, beschrieben. Bei diesem Verfahren wird auf eine Kunststoffplatte beidseitig eine Kupferschicht aufgebracht. Anschließend werden Löcher entweder mechanisch oder mittels eines Laserstrahls durch die Kupferschichten und die Kunststoffplatte entsprechend der gewünschten Anordnung der Verbindungslöcher gebohrt. Aus der Druckschrift Extended Abstracts, Band 83, Nr. 1, Mai 1983, Seite 290, Nr. 179 «Plasmaetching of vias in polyimide using nonerodible masks» ist auch das Plasmaätzen von Durchführungslöchern in Polyimidschichten unter Verwendung von gegen das Plasma resistenten Masken bekannt. Jedoch enthalten die Polyimidschichten keine Glasfaserverstärkung. Bei dem von J.R. Bub u.a. beschriebenen Verfahren (s.o.) werden die Löcher gereinigt und für die stromlose Plattierung mittels einer aus $PdCl_2$ und $SnCl_2$ hergestellten Lösung aktiviert. Dann werden die beiden Kupferschichten mit einer Photolackmaske abgedeckt, welche das Negativ der gewünschten Leiterzugmuster wiedergibt, und schließlich wird stromlos in den Löchern und auf den freiliegenden Bereichen der Kupferschichten Kupfer abgeschieden. Daraufhin werden die Photolackmasken und die dabei freigelegten Bereiche der dünnen Kupferschicht entfernt. Aus den dann vorliegenden Kunststoffplatten wird abwechselnd mit unbehandelten Kunststoffplatten ein Stapel gebildet, der dann laminiert wird. Schließlich werden durchgehende Löcher durch den Stapel gebohrt und deren Wände nach einer Aktivierung (siehe oben) mit Kupfer stromlos plattiert. Beim Erzeugen der Löcher, welche einen Durchmesser von ungefähr 0,25 mm haben, in die ungefähr 0,15 mm dicken und ungefähr 70 × 60 cm großen Platten, und insbesondere auch beim Reinigen der Löcher, z.B. mittels Sandstrahlens, sind die Kunststoffplatten hohen thermischen und/oder mechanischen Belastungen unterworfen. Die Löcher haben einen geringen Abstand voneinander, und es ist deshalb erforderlich, daß beim Bohren oder beim Bearbeiten mit dem Laserstrahl enge Toleranzen einzuhalten sind, was aber bei der Anwendung der genannten Werkzeuge schwierig ist. Das Bohren bzw. das Bestrahlen mit dem Laser dauert außerdem lange und ist apparativ aufwendig. Es kommt hinzu, daß die mechanische Stabilität der Kunststoffplatten beim Erzeugen der Löcher stark vermindert wird, weil dabei das Glasfasergewebe in den Löchern mit entfernt wird. Schließlich sind die leitenden Verbindungen in den mit den genannten Verfahren hergestellten Löchern nicht optimal, weil der Kupferbelag dünn und nicht überall geschlossen ist.

Es ist deshalb die Aufgabe der Erfindung, ein Verfahren anzugeben, mit dem Löcher in glasfaserverstärkten Kunststoffplatten schnell, schonend und billig unter Einhaltung kleiner Fertigungstoleranzen erzeugt werden können und die Anwendung des Verfahrens bei der Herstellung von Kunststoffplatten mit ein- oder beidseitig aufgebrachten Leiterzugmustern und leitenden Durchführungen.

Diese Aufgabe wird mit einem Verfahren der eingangs genannten Art mit den Merkmalen des kennzeichnenden Teils des Patentanspruchs 1 und mit einer Anwendung der eingangs genannten Art mit den Merkmalen des kennzeichnenden Teils des Patentanspruchs 9 gelöst.

Obwohl das Glasfasergewebe bei dem Trokkenätzen praktisch nicht angegriffen wird, wird der Kunststoff im Bereich der Löcher so sauber entfernt, daß eine Nachreinigung der Löcher nicht erforderlich ist. Bei dem erfindungsgemäßen Verfahren werden – anders als bei den bekannten Verfahren – alle in einer Kunststoffplatte zu erzeugenden Löcher – in einer ungefähr 70 × 60 cm großen Platte handelt es sich dabei um größenordnungsmäßig 4000 Löcher – gleichzeitig geätzt, und es gibt bereits Trockenätzgeräte auf dem Markt, mit denen es möglich ist, mehrere solcher Kunststoffplatten gleichzeitig zu ätzen. Da diese Trockenätzgeräte billiger sind als diejenigen, mit denen gebohrt bzw. mit einem Laserstrahl bestrahlt wird und außerdem der Durchsatz höher ist, ist das erfindungsgemäße Verfahren wesentlich wirtschaftlicher als die bekannten. Das erfindungsgemäße Verfahren erlaubt es auch unter Einhaltung sehr kleiner Toleranzen zu ätzen, weshalb Löcher mit einem Durchmesser, der kleiner als 0,25 mm ist, in hoher Flächendichte erzeugt werden können. Da bei dem erfindungsgemäßen Verfahren die Kunststoffplatten weder beim Ätzen, noch, da ein Reinigungsschritt – anders als bei den bekannten Verfahren – nach dem Erzeugen der Löcher nicht nötig ist, danach keinen mechanischen Beanspruchungen ausgesetzt ist, können auch sehr dünne Kunststoffplatten geätzt werden, ohne daß eine Verziehen der Platten stattfindet. Als zusätzlicher Vorteil kommt noch hinzu, daß beim Erzeugen der Löcher das Glasfasergewebe unversehrt bleibt, weshalb die mechanische Stabilität der Kunststoffplatten durch das Einbringen der Löcher praktisch nicht verschlechtert wird.

Es ist vorteilhaft, wenn die Löcher mittels Plasmaätzens in einer $CF_4$ und $O_2$ enthaltenden Atmosphäre erzeugt werden. Dabei ist es günstig, wenn bei einer HF-Leistung zwischen etwa 3 und etwa 6 kW, einem Druck zwischen etwa 0,1 und 1 mbar, einem Gasfluß von 5 Standardliter pro Minute geätzt wird, wobei der $CF_4$-Anteil im Gasfluß zwischen etwa 25 und etwa 45 und der $O_2$-Anteil zwischen etwa 75 und etwa 55 Vol.% liegen.

Das erfindungsgemäße Verfahren ist deshalb zur Anwendung insbesondere zur Herstellung von Kunststoffplatten mit ein- oder beidseitig aufgebrachten Leiterzugmustern und leitenden Durchführungen geeignet, weil die Vorteile des Verfahrens sich auf die Wirtschaftlichkeit, die Genauigkeit und Reproduzierbarkeit dieser Herstellung günstig auswirken. Besonders vorteilhaft wirkt sich bei der genannten Anwendung aus, daß bei dem erfindungsgemäßen Verfahren das Glasfasergewebe in den Löchern nicht mit entfernt wird. Da nämlich bei der Behandlung mit der Palladium- und Zinnchlorid enthaltenden Lösung auch das Glasfasergewebe aktiviert wird, wird beim Verkupfern nicht nur Kupfer auf den Lochwänden, sondern auch auf dem Glasfasergewebe abgeschieden, d.h. daß praktisch das ganze Loch mit Kupfer gefüllt wird. Dadurch wird erreicht, daß die mechanische Stabilität der Kunststoffplatte weiter erhöht wird, daß die leitenden Durchführungen wesentlich besser leiten als die gemäß den bekannten Verfahren hergestellten und daß die Oberfläche im Bereich der Löcher praktisch in einer Höhe mit der Oberfläche der Kunststoffplatte liegt, was den günstigen Effekt hat, daß, wenn man mehrere der so ausgestatteten Kunststoffplatten laminiert, diese weitgehend störungsfrei plan aufeinanderliegen.

Andere vorteilhafte Ausgestaltungen des erfindungsgemäßen Verfahrens und der erfindungsgemäßen Anwendung dieses Verfahrens ergeben sich aus den Unteransprüchen.

Die Erfindung wird anhand von durch Zeichnungen erläuterten Ausführungsbeispielen näher erläutert.

Es zeigen jeweils ausschnittweise:

Fig. 1 in schematischer Querschnittsdarstellung eine Struktur, von welcher bei dem erfindungsgemäßen Verfahren ausgegangen wird,

Fig. 2A in schematischer Querschnittsdarstellung eine Struktur, welche bei dem erfindungsgemäßen Verfahren erzielt wird,

Fig. 2B in schematischer Querschnittsdarstellung die Struktur, welche bei den Verfahren gemäß dem Stand der Technik nach dem Erzeugen der Erfindungslöcher vorliegt und

Fign. 3 und 4 ebenfalls in schematischer Querschnittsdarstellung das Ergebnis von zwei Verfahrensschritten bei der Weiterbehandlung einer erfindungsgemäß hergestellten Struktur.

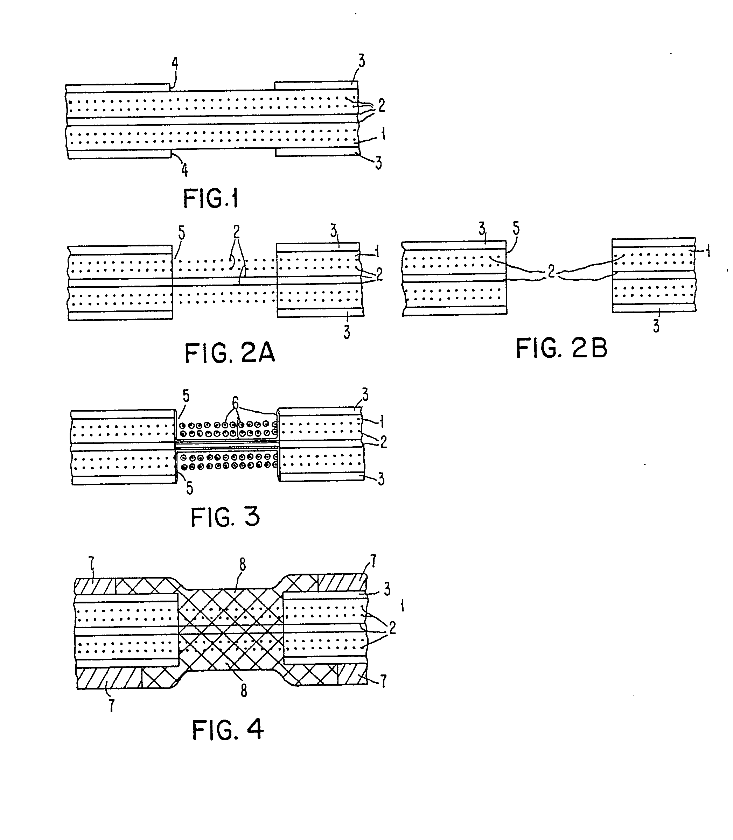

Die folgende ausführliche Beschreibung des erfindungsgemäßen Verfahrens erfolgt anhand der Fign. 1 und 2A. Gemäß der Beschreibung wird das erfindungsgemäße Verfahren so durchgeführt, daß auf der Kunststoffplatte beidseitig Leiterzugmuster erzeugt werden, und auch bei den beschriebenen Anwendungen werden solche beidseitig Leiterzugmuster tragende Kunststoffplatten zugrundegelegt. Es sei aber klargestellt, daß das erfindungsgemäße Verfahren auch funktioniert, wenn Leiterzugmuster nur einseitig oder auch gar nicht vorhanden sind, wobei es jedoch im letzteren Fall schwierig sein dürfte, eine praktische Anwendung zu finden.

Ausgegangen wird von einer Kunststoffplatte 1, welche mit einem Glasfasergewebe 2 verstärkt ist, im übrigen aus einem Polymer, beispielsweise aus einem Epoxidharz, besteht und beispielsweise größenordnungsmäßig 70 × 60 cm groß und 0,1 bis 0,2 mm dick ist. Als Epoxidharz kann beispielsweise das von der Firma Ciba-Geigy unter der Typenbezeichnung Araldid 9302 vertriebene Epoxidharz verwendet werden. Das Glasfasergewebe besteht aus einem alkaliarmen Glas. Auf die Kunststoffplatte 1 wird beidseitig eine dünne Schicht 3 aus einem Maskenmaterial, welches beispielsweise aus Kupfer besteht, aufgebracht. Dies kann beispielsweise dadurch geschehen, daß eine abziehbare Folie, welche im wesentlichen aus einer 5 µm und einer 70 µm dicken Kupferfolie besteht, so auf die Kunststoffplatte laminiert wird, daß die dünnere Kupferfolie, welche außerdem eine relativ rauhe Oberfläche hat, auf die beiden Oberflächen der Kunststoffplatte auflaminiert wird. Anschließend wird entweder nur in der einen oder in beiden Maskenschichten 3 auf photolithographischem Weg ein Lochmuster 4 erzeugt, welches mit dem gewünschten Muster der Verbindungslöcher in der Kunststoffplatte identisch ist. Dies kann beispielsweise dadurch geschehen, daß beidseitig eine Photolackfolie auf die Maskenschichten 2 aufgebracht wird, anschließend ein- oder beidseitig bildmäßig bestrahlt und schließlich entwickelt wird. Als Photolackfolie kann beispielsweise die von der Firma DuPont unter dem Handelsnamen Riston vertriebene Photolackfolie verwendet werden. Wird Riston verwendet, so wird mit 1,1,1-Trichloräthan entwickelt. Anschließend werden die freiliegenden Bereiche der Maskenschicht 3 entfernt. Besteht die Maskenschicht 3 aus Kupfer, so wird dieses beispielsweise mit einer ammoniakalischen $CuCl_2$-Lösung oder einer schwefelsauren Natriumperoxydsulfatlösung weggeätzt. Anschließend wird der Photolack entfernt, wozu im Fall von Riston am besten Methylenchlorid verwendet wird. Einen Ausschnitt aus der nun vorliegenden Struktur zeigt für den Fall, daß das Lochmuster 4 beidseitig erzeugt wird, in schematischer Querschnittsdarstellung die Fig. 1. Bei einer Größe der Kunststoffplatte von 70 × 60 cm und einem Lochdurchmesser von ungefähr 0,25 mm enthält das Lochmuster 4 größenordnungsmäßig 4000 Löcher.

Im folgenden Verfahrensschritt werden in den nicht von der Maskenschicht 3 bzw. den Maskenschichten 3 bedeckten Bereichen der Kunststoffplatte 1 entweder nur von der einen oder – wie es die Fig. 2A zeigt – von beiden Oberflächen aus die Löcher 5 in die Kunststoffplatte 1 trockengeätzt.

Bevorzugt wird beim Trockenätzen ein Plasmaätzverfahren angewandt, welches in einer Atmosphäre, welche CF₄ und O₂ als reaktive Gase enthält, durchgeführt wird.

Beim Plasmaätzen werden üblicherweise Vorrichtungen verwendet, bei denen sich das Werkstück, welches geätzt werden soll, in einer evakuierten Kammer zwischen einem Kathoden-Anoden-Elektrodenpaar befindet, wobei die Hochfrequenz an die Kathode angekoppelt ist, die Anode auf Erdpotential und das Werkstück auf einem gleitenden Potential liegt. Durch die Kammer wird das reaktive Gas hindurchgeleitet. Die Ätzwirkung ist beim Plasmaätzen überwiegend chemisch. In dem Plasma, welches in dem reaktiven Gas zwischen den Elektroden gezündet wird, entstehen reaktive Ionen, welche mit dem Material der Kunststoffplatte flüchtige Reaktionsprodukte bilden und dadurch dessen Abtragung bewirken. Gegenüber dieser chemischen Wirkung der Ionen ist eine Abtragung aufgrund ihrer kinetischen Energie kaum von Bedeutung. Zum Plasmaätzen eignet sich beispielsweise ein Plasmaätzsystem mit parallel zueinander ausgerichteten Elektroden, welches von der Firma Branson unter der Typennummer 7411 vertrieben wird. Das Gerät enthält zehn, je von einem Kathoden-Anoden-Elektrodenpaar eingerahmte Zellen, in welchen jeweils eine Kunststoffplatte der Größe 70 × 60 cm gleichzeitig prozessiert werden kann. Das heißt, es können gleichzeitig zehn Kunststoffplatten dieser Größe geätzt werden. Die Kunststoffplatten stehen beim Ätzen in Ständern aus Aluminium zwischen den Elektroden. Die Ständer und damit auch die Kunststoffplatten sind von der Hochfrequenzspannung und vom Erdpotential elektrisch isoliert. Das Ätzgas wird mittels einer Pumpe mit einer maximalen Pumpengeschwindigkeit von 900 m³ pro Stunde durch die Zellen gesaugt.

Beim Ätzen der Verbindungslöcher in den Kunststoffplatten wird mit einer Hochfrequenzleistung zwischen etwa 3 und etwa 6 kW (13,65 MHz), einem Druck zwischen etwa 0,1 und 1 mbar, einem Gesamtgasfluß zwischen 3 und 7 Standardlitern pro Minute, wobei der CF₄-Anteil in dem Gas zwischen etwa 25 und etwa 45 und der O₂-Anteil zwischen etwa 75 und etwa 55 Vol.% liegen, gearbeitet. Bei dem Verfahren wird das Glasfasergewebe praktisch nicht angegriffen, während das Epoxid ohne irgendwelche Rückstände oder Ablagerungen entfernt wird. Die Fig. 2A zeigt in schematischer Querschnittsdarstellung einen Ausschnitt der Struktur nach dem Trockenätzen. Bei dem Ätzen entstehen die Verbindungslöcher 5, in denen das Glasfasergewebe 2 noch vollständig vorhanden ist.

Der in der Fig. 2B dargestellte Ausschnitt in schematischer Querschnittsdarstellung soll verdeutlichen, was aus der in der Fig. 1 gezeigten Struktur entsteht, wenn die bekannten Verfahren zur Herstellung der Verbindungslöcher, d.h. das Bohren oder das Bearbeiten mit dem Laserstrahl, angewandt werden. Der wesentliche Unterschied zu der in der Fig. 2A gezeigten Struktur besteht darin, daß sich in dem in der Fig. 2B gezeigten Loch 5 kein Glasfasergewebe 2 mehr befindet.

Im folgenden soll anhand von zwei Beispielen das erfindungsgemäße Verfahren noch mehr verdeutlicht werden. Bei beiden Beispielen wurden in je fünf Platten, welche aus Epoxidharz bestanden und 70 × 60 cm groß und 0,15 mm dick waren, ca. 4000 Löcher mit einem Durchmesser von 0,25 mm in der Branson-Plasmaätzvorrichtung geätzt. Die Bedingungen dabei waren:

| Hochfrequenzleistung | 4 kW |
|---|---|
| Frequenz | 13,56 MHz |
| Druck | 0,6 mbar |
| gesamter Gasfluß | 5 SLPM |
| CF₄-Gehalt im Gas | 35 Vol.% |
| O₂-Gehalt im Gas | 65 Vol.%. |

Bei beiden Beispielen war auf die Kunststoffplatten beidseitig eine 5 µm dicke Kupferfolie auflaminiert. Unterschiedlich bei den Beispielen war, daß bei den für das Beispiel 1 benutzten Platten nur in jeweils eine der Kupferfolien und bei den für das Beispiel 2 benutzten Platten jeweils in beide Kupferfolien ein dem gewünschten Muster der Verbindungslöcher entsprechendes Lochmuster geätzt war. Unter den angegebenen Bedingungen lag die Geschwindigkeit, mit welcher das Epoxid geätzt wurde, bei ungefähr 2,5 µm pro Minute. Beim Beispiel 1 wurde ungefähr 65 Minuten lang und beim Beispiel 2 ungefähr 32 Minuten lang geätzt. Es wurde festgestellt, daß das Glasfasergewebe beim Ätzen praktisch nicht angegriffen wurde. Die Dimensionen aller, bei den beiden Beispielen geätzten Löcher, lagen innerhalb eines kleinen Toleranzbereichs. Auch bei der nur von der einen Oberfläche der Kunststoffplatte aus erfolgenden Ätzung (Beispiel 1) erfolgte eine einwandfreie Ätzung des Epoxidharzes bis zur gegenüberliegenden Kupferfolie. In den geätzten Löchern wurden keine partikelförmigen oder schmierigen Ablagerungen festgestellt.

Das erfindungsgemäße Verfahren läßt sich in vorteilhafter Weise in das Verfahren zur Herstellung von Kunststoffplatten mit ein- oder beidseitig aufgebrachten Leiterzugmustern und leitenden Durchführungen, die leitend mit den Leiterzugmustern verbunden sind, einbauen. Die so hergestellten Platten werden entweder in der dann vorliegenden Form oder, nachdem aus mehreren von ihnen und gegebenenfalls dazwischengelegten unbehandelten Kunststoffplatten ein Stapel gebildet, dieser dann laminiert und mit durch eine Kupferauflage leitend gemachten Durchführungslöchern versehen worden ist, beispielsweise als elektrisch verbindende Unterlage für Keramikmoduls, auf welche Halbleiterchips mit integrierten Schaltungen aufgelötet sind, verwendet. Voraussetzung für diese Anwendung des erfindungsgemäßen Verfahrens ist es, daß es möglich ist, gute leitende Verbindungen in den mittels des erfindungsgemäßen Verfahrens hergestellten Löchern zu erzeugen. Diese Voraussetzung wird mit dem erfindungsgemäßen Verfahren nicht nur erfüllt, sondern das erzielte Ergebnis ist sogar besser als bei den bekannten Verfahren. Während bei den bekannten Verfahren im Anschluß an das Erzeugen der Löcher zunächst die Löcher gereinigt werden, bevor sie für die Kupferplattierung aktiviert werden können, ist dieser Reinigungsschritt bei den bekannten Verfahren nicht erforderlich, und bei der Aktivierung mit einer aus Palladium- und Zinnchlorid hergestellten Lösung (die fertige Lösung enthält kolloidales nullwertiges Palladium) wird bei dem erfindungsgemäßen Verfahren – anders als bei den bekannten Verfahren, bei welchen sich in den Löchern ja kein Glasfasermaterial mehr befindet – nicht nur die Lochwand, sondern auch das Glasfasergewebe aktiviert. Dadurch wird erreicht, daß beim nachfolgenden stromlosen Aufbringen des Kupfers Kupfer sich nicht nur an den Lochwänden, sondern auch auf dem Glasfasergewebe abscheidet, weshalb – wie bereits weiter oben ausgeführt worden ist – nicht nur eine verbesserte elektrische Verbindung, sondern auch eine Erhöhung der mechanischen Stabilität erreicht wird.

Der Gesamtprozeß zur Herstellung von Kunststoffplatten mit beidseitig aufgebrachten Leiterzugmustern und leitenden Durchführungen zum Verbinden der Leitungsmuster unter Einschluß des erfindungsgemäßen Verfahrens wird bevorzugt in der folgenden, anhand der Fign. 1, 2A, 3 und 4 erläuterten Weise durchgeführt:

1. Auf eine Kunststoffplatte 1 aus glasfaserverstärktem Epoxidharz, welche ungefähr 70 × 60 cm groß und 0,15 mm dick ist, wird beidseitig eine abziehbare, aus einer dickeren (70 µm) und einer dünneren (5 µm) Kupferfolie bestehende Folie in der Weise auflaminiert, daß die Oberfläche der dünneren Kupferfolie, welche außerdem relativ rauh ist, auf der Kunststoffoberfläche aufliegt. Die dünne Kupferfolie dient als Maskenschicht 3.

2. Die dickere Kupferfolie wird auf beiden Seiten abgezogen.

3. Es folgt dann das erfindungsgemäße Verfahren, wie es weiter oben ausführlich beschrieben worden ist. D.h., daß zunächst in den 5 µm dicken Kupferfolien 3 auf photolithographischem Weg das Lochmuster 4 erzeugt wird (die dann vorliegende Struktur zeigt in schematischer Querschnittsdarstellung die Fig. 1) und daß dann mittels Plasmaätzens unter Verwendung der Kupferfolien 3 als Ätzmasken die Verbindungslöcher 5 geätzt werden. Die dann vorliegende Struktur zeigt die Fig. 2A.

4. Die Wände der Verbindungslöcher 5 und das freiliegende Glasfasergewebe 2 werden dann mit einer Lösung, welche durch Auflösen von Palladium- und Zinnchlorid in einer verdünnten Salzsäurelösung erzeugt worden ist und kolloidales nullwertiges Palladium enthält, für die stromlose Verkupferung aktiviert. Einen Ausschnitt aus der dann vorliegenden Struktur zeigt in schematischer Querschnittsdarstellung die Fig. 3, wobei mit dem Bezugszeichen 6 die aufgebrachte Aktivierung bezeichnet ist.

5. Beidseitig werden dann auf die Kupferfolien 3 eine Photolackfolie, beispielsweise aus Riston, aufgewalzt. Anschließend wird in den Photolackfolien durch bildmäßiges Belichten und entwickeln mit 1,1,1-Trichloräthan Lochmuster erzeugt, welche die gewünschten Leiterzugmuster wiedergeben und in denen damit auch die Verbindungslöcher 5 freiliegen.

6. Auf die freiliegenden Bereiche der Kupferfolie 3 und die aktivierten Bereiche in den Verbindungslöchern 5 wird stromlos Kupfer durch Eintauchen in eine Kupfersulfat, EDTA-Dianhydrid, ein Netzmittel, Formaldehyd und eine geringe Menge Natriumcyanid enthaltende, alkalische Lösung abgeschieden. Die Fig. 4 zeigt in schematischer Querschnittsdarstellung einen Ausschnitt aus der dann vorliegenden Struktur, wobei die Photolackmaske mit dem Bezugszeichen 7 und das aufgebrachte Kupfer mit dem Bezugszeichen 8 bezeichnet sind.

7. Im letzten Verfahrensschritt wird dann die Photolackmaske 7 mit Methylenchlorid abgelöst. Damit ist die Kunststoffplatte mit beidseitig aufgebrachten Leiterzugmustern und leitenden Durchführungen zum Verbinden der Leiterzugmuster fertig.

Soll eine Grundplatte mit mehreren Ebenen von Leiterzugmustern hergestellt werden, so muß der Prozeß fortgesetzt werden.

8. Mehrere in den Verfahrensschritten 1 bis 6 hergestellten Platten werden abwechselnd mit unbehandelten Kunststoffplatten derselben Größe und etwa derselben Dicke in der richtigen Ausrichtung zueinander übereinandergestapelt und dann laminiert. Durch den Stapel hindurch werden Durchführungslöcher gebohrt, anschließend werden die Lochwände aktiviert und stromlos mit einer Kupferlauflage versehen.

So aufgebaute Grundplatten haben üblicherweise eine Dicke von ungefähr 5 mm und enthalten größenordnungsmäßig 15 Kunststoffplatten mit beidseitig aufgebrachten Leiterzugmustern. Diese Grundplatten können mit ihrerseits mehrschichtigen und entsprechend viele Leiterzugebenen aufweisenden Keramikmoduln belegt werden, auf die je eine große Anzahl von Halbleiterchips mit hochintegrierten, dicht gepackten integrierten Schaltungen aufgelötet sind.

## Patentansprüche

1. Verfahren zum Herstellen eines Musters von Verbindungslöchern in glasfaserverstärkten Kunststoffplatten, dadurch gekennzeichnet, daß die Verbindungslöcher durch Trockenätzen der Kunststoffplatten erzeugt werden, wobei die Bedingungen so gewählt sind, daß nur der Kunststoff, aber nicht das Glasfasergewebe (2) der glasfaserverstärkten Kunststoffplatten angegriffen wird.

2. Verfahren nach Anspruch 1, dadurch gekennzeichnet, daß die Verbindungslöcher (5) mittels Plasmaätzens in einer $CF_4$ und $O_2$ enthaltenden Atmosphäre erzeugt werden.

3. Verfahren nach Patentanspruch 1 oder 2, dadurch gekennzeichnet, daß bei einer HF-Leistung zwischen 3 und 6 kW, einem Druck zwischen 0,1 und 1 mbar und einem Gasfluß zwischen 3 und 7 Standardliter pro Minute geätzt wird, wobei das Gasgemisch zwischen 25 und 45 Vol.% $CF_4$ und zwischen 75 und 55 Vol.% $O_2$ enthält.

4. Verfahren nach Patentanspruch 3, dadurch gekennzeichnet, daß bei einer HF-Leistung von etwa 4 kW, einem Druck von etwa 0,6 mbar und einem Gasfluß von etwa 5 Standardliter pro Minute geätzt wird, wobei in dem Gasgemisch etwa 35 Vol.% CF$_4$ und etwa 65 Vol.% O$_2$ enthalten sind.

5. Verfahren nach einem der Ansprüche 1 bis 4, dadurch gekennzeichnet, daß die Ätzung von einer oder gleichzeitig von beiden Oberflächen der Kunststoffplatte (1) aus erfolgt.

6. Verfahren nach einem der Ansprüche 1 bis 5, dadurch gekennzeichnet, daß auf die Kunststoffplatte (1) ein- oder beidseitig eine Maske (3) aus einem Material, welches beim Trockenätzen nicht beachtlich angegriffen wird, aufgebracht wird, wobei mindestens eine der Masken (3) ein Muster von Öffnungen (4), welches dem gewünschten Muster von Verbindungslöchern (5) entspricht, enthält.

7. Verfahren nach Anspruch 6, dadurch gekennzeichnet, daß die Maske (3) aus Kupfer besteht.

8. Verfahren nach einem der Ansprüche 1 bis 7, dadurch gekennzeichnet, daß eine Kunststoffplatte (1) geätzt wird, in welcher der Kunststoff aus einem Epoxidharz besteht.

9. Anwendung des Verfahrens nach einem der Ansprüche 1 bis 8, zur Herstellung von Kunststoffplatten mit ein- oder beidseitig aufgebrachten Leiterzugmustern und leitenden Durchführungen, die leitend mit den Leiterzugmustern verbunden sind, dadurch gekennzeichnet, daß anschließend an das Ätzen der Löcher (5) in die ein- oder beidseitig mit einer Kupfermaske (3) versehenen Kunststoffplatte (1) die Wände der Löcher (5) und das freigelegte Glasfasergewebe (2) mit einer kolloidales Palladium enthaltenden Lösung aktiviert werden, auf die Kupfermasken (3) Photolackmasken (7), welche die Negative der gewünschten Leiterzugmuster (8) wiedergeben, erzeugt, daraufhin stromlos Kupfer auf den freiliegenden Bereichen der Kupfermaske (3) bzw. der Kupfermasken (3), auf den aktivierten Wänden der Löcher (5) und dem aktivierten Glasfasergewebe (2) abgeschieden und schließlich die Photolackmaske (7) und die darunterliegenden Bereiche der Kupfermaske (3) bzw. der Kupfermasken (3) entfernt werden.

10. Anwendung nach Anspruch 9, dadurch gekennzeichnet, daß mehrere der Kunststoffplatten mit ein- oder beidseitig aufgebrachten Leiterzugmustern gegebenenfalls abwechselnd mit unbehandelten Kunststoffplatten zueinander ausgerichtet aufeinandergeschichtet und der Stapel dann laminiert wird, daß durch das Laminat Durchführungslöcher gebohrt werden und schließlich die Wände dieser Durchführungslöcher gereinigt, aktiviert und stromlos mit einer Kupferauflage versehen werden.

**Claims**

1. Method of fabricating a pattern of viaholes in glass fiber reinforced plastic sheets, characterized in that the viaholes are generated by dry-etching the plastic sheets, choosing the conditions such that only the plastic but not the glass fiber meshing (2) of the glass fiber reinforced plastic sheets is attacked.

2. Method as claimed in claim 1, characterized in that the viaholes (5) are generated by means of plasma etching in an atmosphere containing CF$_4$ and O$_2$.

3. Method as claimed in claim 1 or 2, characterized in that etching is effected at an HF power of between 3 and 6 kW and a pressure of between 0.1 and 1 mbar, using a gas flow of between 3 and 7 standard liters per minute, with the gas mixture containing between 25 and 45 volume percent CF$_4$ and between 75 and 55 volume percent O$_2$.

4. Method as claimed in claim 3, characterized in that etching is effected at an HF power of about 4 kW and a pressure of about 0.6 mbar, using a gas flow of about 5 standard liters per minute, with the gas mixture containing about 35 volume percent CF$_4$ and about 65 volume percent O$_2$.

5. Method as claimed in any one of the claims 1 to 4, characterized in that etching is effected from one or simultaneously from both surfaces of the plastic sheet (1).

6. Method as claimed in any one of the claims 1 to 5, characterized in that a mask (3) of a material that is not noticeably attacked during dry etching is unilaterally or bilaterally applied to the plastic sheet (1), with at least one of the masks (3) having a pattern of holes (4) corresponding to the desired pattern of viaholes (5).

7. Method as claimed in claim 6, characterized in that the mask (3) is made of copper.

8. Method as claimed in any one of the claims 1 to 7, characterized in that a plastic sheet (1) is etched in which the plastic consists of an epoxy resin.

9. Application of the method according to any one of the claims 1 to 8 for fabricating plastic sheets with unilaterally or bilaterally applied conductor patterns and via connectors that are conductively linked to the conductor patterns, characterized in that after the holes (5) have been etched into the copper sheet (1) unilaterally or bilaterally provided with a copper mask (3), the walls of the holes (5) and the bared glass fiber meshing (2) are activated with a solution containing colloidal palladium, photoresists masks (7), representing the negatives of the desired conductor patterns (8), are generated on the copper masks (3), copper is electrolessly deposited on the bared regions of the copper mask (3) and the copper masks (3), respectively, the activated walls of the holes (5) and the activated glass fiber meshing (2), and, finally, the photoresist mask (7) and the subjacent regions of the copper mask (3) and the copper masks (3), respectively, are removed.

10. Application according to claim 9, characterized in that several of the plastic sheets with unilaterally or bilaterally applied conductor patterns are alternately packaged, if required, with untreated aligned plastic sheets, and the package is then laminated, that throughholes are drilled through the laminate, and, finally, the walls of these throughholes are cleaned, activated and electrolessly plated with copper.

## Revendications

1. Procédé de fabrication d'un dessin de trous de connexion dans des plaques en matière plastique renforcée de fibres de verre, caractérisé par le fait que l'on produit les trous par attaque chimique à sec des plaques, les conditions étant choisies de manière que seulement la matière plastique, mais non le tissu de fibres de verre (2) des plaques en matière plastique renforcée de fibres de verre soit attaquée.

2. Procédé selon la revendication 1, caractérisé par le fait que l'on produit les trous de connexion (5) pour attaque au plasma dans une atmosphère contenant du $CF_4$ et du $O_2$.

3. Procédé selon la revendication 1 ou 2, caractérisé par le fait que l'on attaque avec une puissance HF comprise entre 3 et 6 kW, une pression comprise entre 0,1 et 1 mbar et un flux de gaz compris entre 3 et 7 litres standard par minute, le mélange de gaz contenant entre 25 et 45% en volume de $CF_4$ et entre 75 et 55% en volume de $O_2$.

4. Procédé selon la revendication 3, caractérisé par le fait qu'on attaque avec une puissance HF d'environ 4 kW, une pression d'environ 0,6 mbar et un flux de gaz d'environ 5 litres standard par minute, environ 35% en volume de $CF_4$ et environ 65% en volume de 0,2 étant contenus dans le mélange de gaz.

5. Procédé selon l'une des revendications 1 à 4, caractérisé par le fait que l'on effectue l'attaque chimique d'une seule surface ou des deux surfaces en même temps de la plaque en matière plastique (1).

6. Procédé selon l'une des revendications 1 à 5, caractérisé par le fait que sur un ou des deux côtés de la plaque en matière plastique (1), on applique un masque (3) en un matériau qui n'est pas notablement atteint lors de l'attaque chimique à sec, au moins l'un des masques (3) comportant un dessin de perforations (4) qui correspond au dessin désiré des trous de connexion (5).

7. Procédé selon la revendication 6, caractérisé par le fait que le masque (3) est réalisé en cuivre.

8. Procédé selon l'une des revendications 1 à 7, caractérisé par le fait qu'on attaque chimiquement une plaque en matière plastique (1) dans laquelle la matière plastique est constituée par une résine époxy.

9. Application du procédé selon l'une des revendications 1 à 8 pour la fabrication de plaques en matière plastique munies de dessins de connexions appliqués d'un seul ou des deux côtés et de traversées conduisant le courant qui sont raccordées de façon conductrice aux dessins des connexions, caractérisée par le fait que consécutivement au perçage des trous (5) dans la plaque en matière plastique (1) munie d'un masque en cuivre (3) d'un seul ou des deux côtés, on active les parois des trous (5) et le tissu de fibres de verre (2) mis à nu avec une solution contenant du palladium colloïdal, que sur les masques en cuivre (3) on forme des masques en photorésist (7) qui reproduisent les négatifs des dessins des connexions désirés (8), après quoi on dépose sans courant du cuivre sur les zones libres du masque en cuivre (3) ou des masques en cuivre (3), sur les parois activées des trous (5) et sur le tissu de fibres de verre activé (2), et que pour finir, on enlève le masque en photorésist (7) et les zones sous-jacentes du masque en cuivre (3) ou des masques en cuivre (3).

10. Application selon la revendication 9, caractérisée par le fait que l'on superpose, en les orientant les unes par rapport aux autres, plusieurs des plaques en matière plastique avec dessins des connexions appliqués d'un seul ou des deux côtés, éventuellement en alternant avec des plaques en matière plastique non traitées, qu'on lamine ensuite la pile, qu'on perce des trous de passage à travers le laminat et que, pour finir, on nettoye et on active les parois de ces trous de passage et on les munit sans courant d'une couche de cuivre.

FIG.1

FIG. 2A

FIG. 2B

FIG. 3

FIG. 4